(19) Europäisches Patentamt / European Patent Office / Office européen des brevets

(11) **EP 4 664 132 A1**

(12) **EUROPÄISCHE PATENTANMELDUNG**

(43) Veröffentlichungstag:
**17.12.2025   Patentblatt 2025/51**

(21) Anmeldenummer: 24182138.8

(22) Anmeldetag: **14.06.2024**

(51) Internationale Patentklassifikation (IPC):
*G01R 31/392* (2019.01)       *H01M 10/48* (2006.01)

(52) Gemeinsame Patentklassifikation (CPC):
**H01M 10/48; G01R 31/392**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft**
**80333 München (DE)**

(72) Erfinder:
• **Fischer, Michael**
  **91320 Ebermannstadt (DE)**
• **Arzberger, Arno**
  **96135 Stegaurach (DE)**

(74) Vertreter: **Siemens Patent Attorneys**
**Postfach 22 16 34**
**80506 München (DE)**

(54) **ERMITTLUNG EINES KALENDARISCHEN KAPAZITÄTSVERLUSTS EINER BATTERIEZELLE**

(57)   Es wird ein Verfahren zur Ermittlung eines kalendarischen Kapazitätsverlusts $\Delta Q$ einer Batteriezelle über einen festgelegten Zeitbereich vorgeschlagen. Das Verfahren ist wenigstens gekennzeichnet durch folgende Schritte:

- (S1) Bereitstellen eines ersten Ladezustands $SOC_1$ zu einem Anfang des Zeitbereichs;

- (S2) Ermitteln eines zweiten Ladezustands $SOC_2$ zu einem Ende des Zeitbereichs;

- (S3) Bereitstellen einer ladezustandsabhängigen Ausdehnungskennlinie $D_{SOC}(SOC)$ (40);

- (S4) Bereitstellen einer vom Kapazitätsverlust $\Delta Q$ abhängigen Ausdehnungskennlinie $D_{loss}(\Delta Q)$ (41);

- (S5) Erfassen einer Ausdehnungsänderung $\Delta D$ (42) der Batteriezelle zwischen Anfang und Ende des Zeitbereichs; und

- (S6) Ermitteln des Kapazitätsverlusts $\Delta Q$ mittels des Zusammenhangs $\Delta D = D_{SOC}(SOC_2) - D_{SOC}(SOC_1) + D_{loss}(\Delta Q)$.

Weiterhin betrifft die Erfindung ein Herstellungsverfahren für eine Batteriezelle.

FIG 4

EP 4 664 132 A1

**Beschreibung**

Die Erfindung betrifft ein Verfahren gemäß dem Oberbegriff des Patentanspruches 1 sowie ein Herstellungsverfahren gemäß dem Oberbegriff des Patentanspruches 10.

Batteriezellen, insbesondere basierend auf Lithium-Ionen Technologien, finden zunehmend Verwendung in Anwendungen mit höheren Ansprüchen an deren Leistungsfähigkeit und Langlebigkeit.

Um die genannten technischen Anforderungen mit einer ausreichenden Qualität sicherzustellen, durchlaufen Batteriezellen, insbesondere im Rahmen ihrer Herstellung, mehrere Qualitätstests. Dadurch wird eine Bewertung der jeweiligen Batteriezelle (englisch: Grading) ermöglicht. Hierbei können Batteriezellen mit geringerer Qualität von hochqualitativen Zellen unterschieden werden.

Mit steigenden Anforderungen an die Batteriezellen erhöhen sich ebenfalls die Anforderungen an die genannten Qualitätstests beziehungsweise an das Grading. Ein verbessertes Qualitätsverfahren liefert beispielsweise Aussagen darüber, ob die produzierten Batteriezellen tatsächlich eine spezifizierte Lebensdauer gewährleisten, oder ob beispielsweise Schwankungen in den Produktionsbedingungen zu einer erhöhten Alterungsrate der Batteriezelle geführt haben.

Unter einer Alterung einer Batteriezelle versteht man typischerweise den kontinuierlich zunehmenden Verlust der Kapazität einer Batteriezelle. Die Kapazität bezeichnet die elektrische Ladung, die eine Batteriezelle maximal zur Verfügung stellen kann, wenn sie über ihren maximal spezifizierten Spannungsbereich entladen wird. Die Rate dieses Verlusts ist typischerweise abhängig von Umgebungsbedingungen, Betriebsbedingungen und von der Qualität der Batteriezelle selbst. Hierbei werden typischerweise zyklische Verluste, die als Folge eines Ladezyklus oder Entladezyklus auftreten, und kalendarische Verluste, die mit der Zeit zunehmen, selbst wenn die Zelle nicht verwendet wird, unterschieden.

Insbesondere sind Messung der kalendarischen Alterungsrate nur mit einem hohen Aufwand möglich, sodass eine darauf basierte Qualitätsbewertung der Batteriezellen, insbesondere im Rahmen ihrer Herstellung, schwierig sicherzustellen ist.

Somit wird die kalendarische Alterung einer hergestellten Batteriezelle nicht individuell ermittelt. Es werden stattdessen stichprobenartig Batteriezellen aus der Produktion entnommen und in langen und aufwändigen Tests untersucht. Hierbei kann die kalendarische Alterung durch Lagerung der Batteriezellen bei definierten Temperaturen über längere Zeiträume grundsätzlich bestimmt werden. Allerdings kann dadurch nicht bei jeder produzierten Batteriezelle mit Sicherheit erkannt werden, ob diese auch die spezifizierte kalendarische Lebensdauer aufweist.

Nach dem Stand der Technik wird innerhalb einer Batteriezellenproduktion ein sogenannter Alterungsprozess (englisch: Aging) durchgeführt. Hierzu werden die Batteriezellen nach ihrer Formierung bei definierten Bedingungen für mehrere Tage gelagert. Dieser Lagerungsprozess wird typischerweise dafür verwendet die Selbstentladung der Batterie beziehungsweise der Batteriezelle während dieses Zeitraums zu bestimmen, um darauf basierend eine Bewertung der einzelnen Batteriezelle zu ermöglichen. Allerdings ist die Alterung der Batteriezellen während weniger Tage im Vergleich zu ihrer vorgesehenen Lebensdauer gering, sodass ein Ermitteln und Bewerten der individuellen Alterung eine technische Herausforderung ist.

Als eine erste Möglichkeit kann die verfügbare Kapazität vor und nach der Alterung gemessen werden. Hierzu wird die Batteriezelle jeweils über ihren gesamten Spannungsbereich entladen und die hierbei entnommene Ladungsmenge gemessen. Aus der Differenz der Ladungsmengen ergibt sich dann der Kapazitätsverlust, der beim Alterungsprozess aufgetreten ist. Hieraus kann die Alterungsrate ermitteln werden. Nachteilig daran ist, dass die hierzu erforderlichen Kapazitätsmessungen sehr genau durchgeführt werden müssen. Insbesondere ist es hierbei erforderlich, die Batteriezellen vor und nach ihrer Alterung in den gleichen definierten Ausgangszustand vor Beginn der Entladung zu bringen. Dies erfordert zusammen mit dem Entladeprozess selbst einiges an Zeit, wodurch Messkanäle länger belegt sind. Dies ist somit mit signifikanten Investitionskosten für die erforderlichen Messkanäle verbunden. Zudem wird durch die vollständige Aufladung beziehungsweise Entladung zur Kapazitätsbestimmung selbst eine zyklische Alterung der Zelle provoziert, die sich mit der kalendarischen Alterung überlagert.

Als eine zweite Möglichkeit zur Ermittlung der Alterung werden nach dem Stand der Technik Widerstandsmessungen vor und nach der Alterung der Batteriezelle herangezogen. Sofern ein Zusammenhang zwischen dem komplexen und frequenzabhängigen Innenwiderstand der Batteriezelle und deren Alterungszustand vorliegt, können die Änderungen ausgewählter Widerstandsmessungen verwendet werden, um die Alterung nach dem Lagerungsprozess zu ermitteln. Nachteilig hieran ist, dass ein solcher Zusammenhang typischerweise nicht eindeutig ist und weitere zellinterne Prozesse, wie sie bei der Lagerung nach der Formierung noch erfolgen können, können die Widerstandsmessung signifikant beeinflussen. Weiterhin müsste auch hier ein definierter Zustand der Batteriezelle vor der Widerstandsmessung sichergestellt werden. Dadurch werden wiederum Zeit und Kosten deutlich erhöht.

Zusammenfassend weist jede der bekannten Methoden wesentliche Nachteile auf, sodass keine dieser Methoden eine besonders vorteilhafte Möglichkeit zur Bestimmung der kalendarischen Alterung bereitstellt.

Der vorliegenden Erfindung liegt die Aufgabe zugrunde, ein verbessertes Verfahren zur Ermittlung der kalendarischen Alterung einer Batteriezelle bereitzustellen.

Die Aufgabe wird durch ein Verfahren mit den Merkmalen des unabhängigen Patentanspruches 1 sowie durch ein Verfahren mit den Merkmalen des unabhängigen Patentanspruches 10 gelöst. In den abhängigen Patentansprüchen sind vorteilhafte Ausgestaltungen und Weiterbildungen der Erfindung angegeben.

Das erfindungsgemäße Verfahren zur Ermittlung eines kalendarischen Kapazitätsverlusts $\Delta Q$ einer Batteriezelle über einen festgelegten Zeitbereich, ist wenigstens gekennzeichnet durch folgende Schritte:

- Bereitstellen eines ersten Ladezustands $SOC_1$ zu einem Anfang des Zeitbereichs;
- Ermitteln eines zweiten Ladezustands $SOC_2$ zu einem Ende des Zeitbereichs;
- Bereitstellen einer ladezustandsabhängigen Ausdehnungskennlinie $D_{SOC}(SOC)$;
- Bereitstellen einer vom Kapazitätsverlust $\Delta Q$ abhängigen Ausdehnungskennlinie $D_{loss}(\Delta Q)$;
- Erfassen einer Ausdehnungsänderung $\Delta D$ der Batteriezelle zwischen Anfang und Ende des Zeitbereichs; und
- Ermitteln des Kapazitätsverlusts $\Delta Q$ mittels des Zusammenhangs $\Delta D = D_{SOC}(SOC_2) - D_{SOC}(SOC_1) + D_{loss}(\Delta Q)$.

Das erfindungsgemäße Verfahren und/oder eine oder mehrere Funktionen, Merkmale und/oder Schritte des erfindungsgemäßen Verfahrens und/oder einer seiner Ausgestaltungen können computergestützt sein. Insbesondere kann das Lösen des Zusammenhangs beziehungsweise der Gleichung $\Delta D = D_{SOC}(SOC_2) - D_{SOC}(SOC_1) + D_{loss}(\Delta Q)$ numerisch erfolgen.

Die Reihenfolge der Schritte des Verfahrens impliziert grundsätzlich keine zeitliche Abfolge der genannten Schritte.

Eine Ausdehnungskennlinie kann ein funktionaler Zusammenhang sein, der die Ausdehnung der Batteriezelle, relativ oder absolut, in Abhängigkeit des Ladezustands (englisch: State of Charge; SOC) beziehungsweise in Abhängigkeit des Ladungsverlusts beziehungsweise des Kapazitätsverlusts kennzeichnet beziehungsweise quantifiziert. Diese kann numerisch, tabellarisch und/oder als Funktion vorliegen.

Die ladezustandsabhängige Ausdehnungskennlinie und/oder die vom Kapazitätsverlust abhängige Ausdehnungskennlinie können vorab mittels Testverfahren, insbesondere mittels einer oder mehrerer Referenzbatteriezellen, ermittelt werden.

Die den Ausdehnungskennlinien zugrundliegende Ausdehnung der Batteriezelle kann eine absolute räumliche Ausdehnung der Batteriezelle, beispielsweise in einer räumlichen Richtung, eine relative Ausdehnung bezüglich einer ursprünglichen beziehungsweise initialen Ausdehnung der Batteriezelle (Differenzwert zur ursprünglichen Ausdehnung), eine auf eine ursprüngliche beziehungsweise initiale Ausdehnung der Batteriezelle normierte Ausdehnung und/oder eine relative Änderung der räumlichen absoluten Ausdehnung der Batteriezelle bezüglich einer ursprünglichen beziehungsweise initialen Ausdehnung der Batteriezelle (Differenzenquotient) sein. Insbesondere ist die Ausdehnung ein auf ein ursprüngliches Volumen normiertes Volumen.

Gemäß einem ersten Schritt des erfindungsgemäßen Verfahren wird der erste Ladezustands zum Anfang des Zeitbereichs bereitgestellt. Mit anderen Worten weist die Batteriezelle zu Beginn des Zeitbereichs, der insbesondere mit dem Beginn einer Lagerung der Batteriezelle assoziiert ist, den ersten Ladezustand auf. Der erste Ladezustand wird bereitgestellt, das heißt, dass dieser zum Beginn des Zeitbereichs bekannt ist oder dieser messtechnisch erfasst wird. Beispielsweise kann die Batteriezelle zum Beginn ihrer Lagerung im Rahmen ihrer Herstellung im Wesentlichen vollständig geladen sein, was einem ersten Ladezustand von im Wesentlichen 100 Prozent entspricht. Ein vollständiges Geladen sein ist jedoch grundsätzlich nicht erforderlich, sodass der initiale beziehungsweise der erste Ladezustand von 100 Prozent abweichen kann. Typischerweise werden die Batteriezellen jedoch mit einem hohen Ladezustand, beispielsweise oberhalb von 80 Prozent, eingelagert.

In einem zweiten Schritt des Verfahrens wird der zweite Ladezustand der Batteriezelle am Ende des Zeitbereichs ermittelt. Mit anderen Worten weist die Batteriezelle zum Ende des Zeitbereichs, der insbesondere mit dem Ende der Lagerung der Batteriezelle assoziiert ist, den zweiten Ladezustand auf. Der zweite Ladezustand wird vorliegend ermittelt. Der zweite Ladezustand kann insbesondere mittels einer Messung der Ruhespannung ermittelt werden. Das ist deshalb der Fall, da die Ruhespannung vom Ladezustand der Batteriezelle abhängig ist. Diese Abhängigkeit kann ebenfalls als Kennlinie (Ruhespannungskennlinie) vorliegen und zur Ermittlung des zweiten Ladezustands über ein Erfassen der Ruhespannung herangezogen werden.

Gemäß einem dritten Schritt des Verfahrens wird die ladezustandsabhängige Ausdehnungskennlinie $D_{SOC}(SOC)$ bereitgestellt. Mit anderen Worten ist damit bekannt, wie sich die Ausdehnung der Batteriezelle mit ihrem Ladezustand ändert.

In einem vierten Schritt des Verfahrens wird die vom Kapazitätsverlust $\Delta Q$ abhängige Ausdehnungskennlinie $D_{loss}(\Delta Q)$ bereitgestellt. Mit anderen Worten ist damit bekannt, wie sich die Ausdehnung der Batteriezelle mit ihrem Kapazitätsverlust, den die Batteriezelle über die Zeit, das heißt mit ihrer Alterung, aufweist, ändert.

In einem fünften Schritt des Verfahrens wird eine Ausdehnungsänderung $\Delta D$ der Batteriezelle zwischen Anfang und Ende des Zeitbereichs erfasst. Mit anderen Worten ist damit bekannt, wie sich die Ausdehnung der Batteriezelle über den Zeitbereich, insbesondere ihre Lagerung, geändert hat. Hierzu kann beispielsweise eine initiale Ausdehnung $D_1 = D_{Start}$ der Batteriezelle am Anfang des Zeitbereichs und eine finale Ausdehnung $D_2 = D_{End}$ der Batteriezelle am Ende des Zeitbereichs erfasst werden. Die Ausdehnungsänderung ergibt sich dann gemäß $\Delta D = D_2 - D_1$.

Gemäß einem sechsten Schritt des Verfahrens wird der Kapazitätsverlust $\Delta Q$ mittels des Zusammenhangs $\Delta D = D_{SOC}(SOC_2) - D_{SOC}(SOC_1) + D_{loss}(\Delta Q)$ ermittelt. Hierbei sind alle Größen bis auf den Kapazitätsverlust bereitgestellt und/oder ermittelt, sodass der Kapazitätsverlust eindeutig durch die Gleichung $\Delta D = D_{SOC}(SOC_2) - D_{SOC}(SOC_1) + D_{loss}(\Delta Q)$ bestimmt werden kann. Mit anderen Worten ist $\Delta Q = F(SOC_1, SOC_2, \Delta D)$ eine bekannte Funktion der erfassten und bereitgestellten Größen.

Durch die erfindungsgemäße Verwendung der Ausdehnung beziehungsweise der Ausdehnungskennlinien kann somit die kalendarische Alterung, die mit dem kalendarischen Kapazitätsverlust assoziiert ist, von der Selbstentladung der Batteriezelle getrennt werden. Dadurch kann der kalendarische Kapazitätsverlust ermittelt werden, obwohl messtechnisch lediglich die Überlagerung von kalendarischen Verlust und Selbstentladung, nämlich $\Delta D$, zugänglich ist. Durch die Kennlinien ist jedoch deren einzelner Einfluss auf die Ausdehnungsänderung $\Delta D$ bekannt.

Hierbei wurde vorausgesetzt, dass die Spannungskennlinien und Ausdehnungskennlinien für einen vorliegenden Zelltyp der Batteriezelle bekannt sind und sich insbesondere während des Alterungsprozesses der Batteriezelle nicht wesentlich verändern. Da die zu erwartende Alterung gering ist, ist dies typischerweise in sehr guter Näherung gegeben. Falls die Alterung, das heißt der Verlust an speicherbarer Ladungsmenge (Kapazitätsverlust), während des Zeitbereichs, insbesondere während der Lagerung, so hoch ausfällt, dass hierdurch Änderungen der Kennlinien zu erwarten wären, so kann dies ebenfalls und entsprechend berücksichtigt werden.

Im Vergleich zu bekannten Verfahren, welche auf stichprobenartigen Tests basieren, kann durch die Erfindung die kalendarische Alterung für jede Batteriezelle beziehungsweise hergestellte Batteriezelle individuell bestimmt werden. Hierdurch kann eine individuelle Bewertung (Grading) der Batteriezelle erfolgen. Dadurch wird insbesondere sichergestellt, dass jede Batteriezelle ihre Lebensdauer-Spezifikationen erfüllt. Weiterhin kann somit der Umfang und die Notwendigkeit von aufwändigeren Alterungstests an Batteriezellen reduziert werden.

Bekannte Untersuchungen der Ausdehnungen sowie von Volumen- und Druckänderungen im Rahmen der Batterieproduktion beziehen sich lediglich auf sehr grobe Aussagen über die Zellqualität. Beispielsweise wenn die Zelle deutlich sichtbar anschwillt, so weist dies auf eine größere Fehlfunktion hin. Dies ist vom vorliegenden Verfahren mit einer genauen Ausdehnungsmessung zur kalendarischen Lebensdauerbestimmung zu unterscheiden.

Weiterhin hat das erfindungsgemäße Verfahren den Vorteil, dass hierzu keine besonderen zusätzlichen Messaufbauten und/oder Prozesszeiten erforderlich sind. Die Ausdehnungsänderung kann vergleichsweise schnell, genau und in kurzer Zeit mittels bekannter Messmethoden ermittelt werden.

Das erfindungsgemäße Herstellungsverfahren für eine Batteriezelle, bei welchem die Batteriezelle für wenigstens einen Zeitbereich lastfrei gelagert wird, ist gekennzeichnet dadurch, dass ein kalendarischer Kapazitätsverlust der Batteriezelle über die Lagerung mittels einem Verfahren gemäß der Erfindung und/oder einer ihrer Ausgestaltungen ermittelt wird.

Es ergeben sich zum erfindungsgemäßen Verfahren gleichartige, gleichwertige und gleichwirkende Vorteile und/oder Ausgestaltungen des erfindungsgemäßen Herstellungsverfahrens.

Gemäß einer vorteilhaften Ausgestaltung der Erfindung wird eine kalendarische Alterung mittels $\Delta Q/Q_0$ ermittelt, wobei $Q_0$ die Nennkapazität der Batteriezelle bezeichnet.

Mit anderen Worten wird somit im Rahmen des Herstellungsverfahrens die kalendarische Alterung der Batteriezelle vorteilhafterweise über die Lagerung ermittelt. Dies kann insbesondere am Ende und/oder nach der Lagerung erfolgen. Typischerweise erfolgt die Lagerung der Batteriezelle am Ende ihres Herstellungsprozesses, das heißt am Ende des Herstellungsverfahrens.

Vorteilhafterweise kann der kalendarische Kapazitätsverlust $\Delta Q$ mittels der Erfindung unabhängig von einer Selbstentladung der Batteriezelle bestimmt werden. Dadurch kann die kalendarische Alterung $\Delta Q/Q_0$ verbessert ermittelt werden. Vorteilhafterweise erfolgt dies batteriezellenspezifisch und nicht basierend auf statistischen Methoden und Stichproben.

In einer vorteilhaften Weiterbildung der Erfindung wird eine kalendarische Alterungsrate der Batteriezelle mittels $\Delta Q/T_0$ ermittelt, wobei $T_0$ die Zeitdauer des Zeitbereichs bezeichnet.

Mit anderen Worten wird somit im Rahmen des Herstellungsverfahrens die kalendarische Alterungsrate der Batteriezelle vorteilhafterweise über die Lagerung ermittelt. Dies kann insbesondere am Ende und/oder nach der Lagerung erfolgen. Alternativ oder ergänzend kann eine normierte kalendarische Alterungsrate mittels $\Delta Q/(Q_0 T_0)$ ermittelt werden.

Vorteilhafterweise kann der kalendarische Kapazitätsverlust $\Delta Q$ mittels der Erfindung unabhängig von einer Selbstentladung der Batteriezelle bestimmt werden. Dadurch kann die kalendarische Alterungsrate $\Delta Q/T_0$ verbessert ermittelt werden. Vorteilhafterweise erfolgt dies batteriezellenspezifisch und nicht basierend auf statistischen Methoden und Stichproben. Im Rahmen eines Herstellungsverfahrens ist $T_0$ die Lagerzeit beziehungsweise die Lagerdauer der Batteriezelle.

Gemäß einer vorteilhaften Ausgestaltung der Erfindung wird die Batteriezelle innerhalb des Zeitbereichs lastfrei gelagert.

Mit anderen Worten erfolgt eine stromfreie Lagerung der Batteriezelle. Die Batteriezelle wird somit weder geladen noch entladen. Dadurch bildet sich zwischen den Elektroden der Batteriezelle die Ruhespannung aus, die vorteilhafterweise zur Ermittlung des ersten und/oder zweiten Ladezustandes verwendet werden kann.

In einer vorteilhaften Weiterbildung der Erfindung werden die Ausdehnungskennlinien in Abhängigkeit des Zelltyps der Batteriezelle bereitgestellt.

Mit anderen Worten sind die Ausdehnungskennlinien vom Typ der Batteriezelle abhängig. Es ist somit vorteilhaft den Typ der Batteriezelle bei der Bereitstellung der Ausdehnungskennlinien zu berücksichtigen. Dadurch wird die Ermittlung des kalendarischen Kapazitätsverlusts verbessert.

Gemäß einer vorteilhaften Ausgestaltung der Erfindung wird eine maximale Kapazität der Batteriezelle ermittelt, und der ermittelte Kapazitätsverlust $\Delta Q$ mittels eines von der ermittelten maximalen Kapazität abhängigen Korrekturfaktors korrigiert.

Mit anderen Worten wird der kalendarische Kapazitätsverlust gemäß $\Delta Q \rightarrow K \cdot \Delta Q$ korrigiert, wobei $K$ der von der maximalen Kapazität abhängige Korrekturfaktor ist. Dadurch wird die Ermittlung des kalendarischen Kapazitätsverlusts weiter verbessert, insbesondere ist dadurch eine höhere Genauigkeit der Ermittlung möglich. Der Korrekturfaktor weist typischerweise einen Wert im Bereich von Null bis Eins auf, wobei der Wert Eins vorliegt, wenn die maximale Kapazität der Batteriezelle ihrer Nennkapazität $Q_0$ im Wesentlichen entspricht. Alternativ oder ergänzend ist $K = Q_{real}/Q_0$, wobei $Q_{real}$ die tatsächliche Kapazität der Batteriezelle bezeichnet, die von der Nennkapazität verschieden sein kann. In diesem Fall ist $D_{loss} = D_{loss}(\Delta Q/Q_0)$.

Im Rahmen des Herstellungsverfahren wird der kalendarische Kapazitätsverlust ebenfalls bevorzugt mittels des Korrekturfaktors K korrigiert.

In einer vorteilhaften Weiterbildung der Erfindung werden der erste und/oder zweite Ladezustand $SOC_1$, $SOC_2$ mittels einer Ruhespannungskennlinie $V_{OC}(SOC)$ der Batteriezelle ermittelt.

Vorteilhafterweise sind die Ruhespannungskennlinien von Batteriezellen typischerweise bekannt, sodass mittels dieser der erste und/oder zweite Ladezustand effizient ermittelt werden können. Die Ruhespannung ist zudem messtechnisch zugänglich. Zur Ermittlung der Ladezustände müssen daher die jeweiligen aktuellen Ruhespannungen erfasst werden, die dann mittels der Ruhespannungskennlinie in die Ladezustände umgerechnet werden können.

Gemäß einer vorteilhaften Ausgestaltung der Erfindung wird die Ausdehnungsänderung $\Delta D$ mittels eines Dilatometers, einer Kraftmessung, einer Druckmessung, ultraschallbasierten Verfahren, optischen Verfahren und/oder mittels Dehnungsmessstreifen erfasst.

Vorteilhafterweise ermöglichen die genannten Messverfahren eine besonders genaue Ermittlung der Ausdehnung. Zudem sind die genannten Messverfahren vorteilhafterweise während eines Betriebes und/oder der Lagerung der Batteriezelle möglich. Gemäß den genannten Messverfahren kann die Ausdehnung somit direkt oder indirekt ermittelt und somit erfasst werden.

Weiterhin ist die Verwendung der Ausdehnung besonders für Lithium-Ionen-Zellen mit einer erhöhten Energiedichte vorteilhaft. Das ist deshalb der Fall, da sich diese mit ihrer Alterung messbar ausdehnen.

Auch die nächsten Generationen von Batterien beziehungsweise Batteriezellen, beispielsweise basierend auf Festkörper Elektrolyten und/oder metallischem Lithium und/oder Natrium, sowie solche basierend auf der Interkalation von Natriumionen, weisen eine größere Volumenänderungen auf, die im Sinne der vorliegenden Erfindung als Ausdehnung herangezogen werden können.

In einer vorteilhaften Weiterbildung der Erfindung ist die Batteriezelle als Lithium-Ionen-Batteriezelle ausgebildet.

Diese weisen vorteilhafterweise, wie bereits obenstehend genannt, eine vorteilhafte Ausdehnungsänderung aus, sodass das Verfahren besonders bevorzugt bei Lithium-Ionen-Batteriezellen verwendet werden kann.

Weiterhin kann die Batteriezelle bevorzugt als Natrium-Ionen-Zelle ausgebildet sind.

Im Rahmen des Herstellungsverfahren ist es somit vorteilhaft, dass als Batteriezelle eine als Lithium-Ionen-Batteriezelle hergestellt wird.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:

Figur 1     ein Ablaufdiagramm eines Verfahrens gemäß einer Ausgestaltung der Erfindung;

Figur 2     zwei Diagramme bezüglich der Ruhespannung einer Batteriezelle;

Figur 3     zwei Ausdehnungskennlinien; und

Figur 4     ein Diagramm bezüglich einer zeitlichen Ausdehnungsänderung einer Batteriezelle.

Gleichartige, gleichwertige oder gleichwirkende Elemente können in einer der Figuren oder in den Figuren mit denselben Bezugszeichen versehen sein.

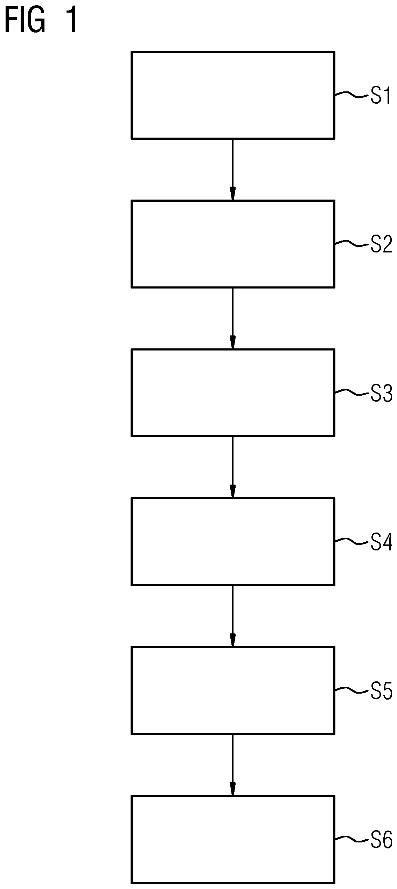

Die Figur 1 zeigt ein Verlaufsdiagramm eines Verfahrens zur Ermittlung eines kalendarischen Kapazitätsverlusts einer Batteriezelle, insbesondere einer Lithium-Ionen-Batterie, gemäß einer Ausgestaltung der Erfindung.

Hierbei wird das Verfahren exemplarisch im Rahmen eines Herstellungsverfahren der Batteriezellen beschrieben. Typischerweise wird die Batteriezelle am Ende ihrer Herstellung für einen festgelegten Zeitbereich lastfrei gelagert.

In einem ersten Schritt S1 wird ein erster Ladezustand $SOC_1$ zum Anfang der Lagerung (Zeitbereich) der Batteriezelle bereitgestellt oder ermittelt.

Gemäß einem zweiten Schritt S2 wird ein zweiter Ladezustand $SOC_2$ zum Ende der Lagerung der Batteriezelle ermittelt.

Die Ladezustände $SOC_1$, $SOC_2$ können mittels einer Ruhespannungskennlinie der Batteriezelle ermittelt werden.

Beim Alterungsprozess werden die Batteriezellen typischerweise mit einem relativ hohen Ladezustand gelagert, ohne dass ein elektrischer Strom fließt. Mit anderen Worten erfolgt eine lastfreie Lagerung mit einem vergleichsweise hohen ersten Ladezustand.

Der Ladezustand hängt über die Ruhespannungskennlinie mit der an der Batteriezelle messbaren Ruhespannung zusammen. Während der typischerweise mehrtägigen Lagerung der Batteriezelle ändert sich ihre Ruhespannung. Dies liegt insbesondere an der Selbstentladung der Batteriezelle, welche dazu führt, dass sich der Ladezustand der Batteriezelle mit der Zeit verringert. Dies induziert eine entsprechende Änderung der Ruhespannung. Somit kann ebenfalls durch eine Messung der Ruhespannung, insbesondere am Ende und am Anfang des Lagerungsprozesses, die Selbstentladungsrate bestimmt werden. Weiterhin können die Ladezustände am Anfang und am Ende der Lagerung der Batteriezelle, das heißt der erste und zweite Ladezustand ermittelt werden.

Neben der Selbstentladung erfährt die Batteriezelle während ihrer Lagerung zusätzlich eine kalendarische Alterung, die sich jedoch nicht wesentlich in der messbaren Ruhespannung niederschlägt, wie das folgende Beispiel verdeutlicht:

Ausgehend von einer Lagerung von fünf Tagen, einer Selbstentladung pro Monat von 3 Prozent, 2000 Lebenszyklen und zehn Jahren rein kalendarischer Lebensdauer (jeweils bis 80 Prozent Restkapazität) ergibt sich typischerweise eine Selbstentladung während dem Alterungsprozess von etwa 0,5 Prozent, ein kalendarischer Kapazitätsverlust während dem Alterungsprozess von etwa 0,027 Prozent und ein Kapazitätsverlust pro Zyklus von 0,01 Prozent. Hierbei wurde jeweils von vergleichbaren Bedingungen, beispielsweise bezüglich Raumtemperatur, Luftfeuchtigkeit und/oder initialer Ladezustand der Batteriezelle, während des Alterungsprozesses beziehungsweise während der Lagerung der Batteriezelle ausgegangen. Grundsätzlich würde eine erhöhte Temperatur zu einer Beschleunigung des Alterungsprozesses und der Selbstentladungsprozesse führen.

Das obenstehende Beispiel verdeutlicht somit, dass der kalendarische Kapazitätsverlust vergleichsweise gering ist. Das vorliegende Ausführungsbeispiel der Erfindung löst dies durch die Verwendung von Ausdehnungskennlinien, mittels welchem der kalendarische Kapazitätsverlust von der Selbstentladung getrennt und genau ermittelt werden kann.

Hierzu ist der dritte und vierte Schritt S3, S4 vorgesehen, demnach eine ladezustandsabhängige Ausdehnungskennlinie $D_{SOC}(SOC)$ sowie eine vom Kapazitätsverlusts $\Delta Q$ abhängige Ausdehnungskennlinie $D_{loss}(\Delta Q)$ bereitgestellt werden.

Die Ausdehnungskennlinien können vorab, insbesondere batteriezellentypspezifisch, mittels Testverfahren ermittelt werden.

Gemäß einem fünften Schritt S5 wird somit zur Ermittlung des kalendarischen Kapazitätsverlusts $\Delta Q$ die Ausdehnung der Batteriezelle am Anfang und am Ende des Alterungsprozesses oder ebenfalls während des Prozesses gemessen und somit die Ausdehnungsänderung $\Delta D$ ermittelt. Die Ausdehnungsänderung ist hierbei vom Ladezustand der Batteriezelle und ihrer Alterung abhängig, das heißt, dass die erfasste Ausdehnungsänderung zunächst beide Effekte, die Selbstentladung und die Alterung, umfasst. Es ist eine Erkenntnis der Erfindung, dass diese durch die Verwendung der genannten Ausdehnungskennlinien entkoppelt werden können.

Diese Entkopplung erfolgt gemäß einem sechsten Schritt S6, bei dem der Kapazitätsverlust $\Delta Q$ mittels des Zusammenhangs $\Delta D = D_{SOC}(SOC_2) - D_{SOC}(SOC_1) + D_{loss}(\Delta Q)$ ermittelt wird.

Im genannten Zusammenhang sind die Abhängigkeiten durch die Bereitstellung der Ausdehnungskennlinien bekannt. Weiterhin sind die Werte der weiteren Variablen $SOC_1$, $SOC_2$ und $\Delta D$ durch ihre Ermittlung beziehungsweise Messung bekannt, sodass eindeutig auf den kalendarischen Kapazitätsverlust $\Delta Q$ geschlossen werden kann. Formal kann dies durch $\Delta Q =$

$$D_{loss}^{-1}[\Delta D - D_{SOC}(SOC_2) - D_{SOC}(SOC_1)]$$ dargestellt werden, wobei $D_{loss}^{-1}$ die Umkehrfunktion von $D_{loss}(\Delta Q)$ bezeichnet. Dadurch ist der kalendarische Kapazitätsverlust $\Delta Q$ unabhängig von der Selbstentladung und mit vorteilhafter Genauigkeit ermittelt beziehungsweise ermittelbar.

Die Erfindung macht sich somit die Messung der Ausdehnungsänderung beziehungsweise der Größenänderung der Batteriezelle während des Alterungsprozesses, beispielsweise während ihrer Lagerung, zunutze, um den kalendarischen Kapazitätsverlust während dieser Zeit zu ermitteln. Basierend hierauf kann eine verbesserte Bewertung (Grading) der individuellen Batteriezelle erfolgen.

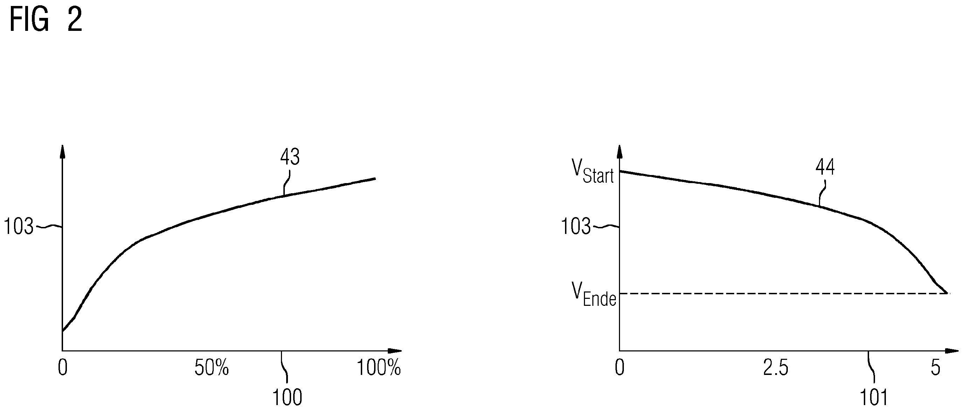

Die Figur 2 zeigt ein linkes und ein rechtes Diagramm bezüglich der Ruhespannung einer Batteriezelle.

An der Abszisse 100 des linken Diagramms ist der Ladezustand (SOC) der Batteriezelle in Prozent aufgetragen.

An der Abszisse 101 des rechten Diagramms ist die Zeit, insbesondere eine Lagerdauer der Batteriezelle, in Tagen aufgetragen.

An den Ordinaten 103 der Diagramme ist jeweils die Ruhespannung in beliebigen Einheiten, insbesondere in Volt, aufgetragen.

Das linke Diagramm zeigt eine mit dem Ladezustand der Batteriezelle ansteigende Ruhespannung $V_{OC}(SOC)$ beziehungsweise Ruhespannungskennlinie 43. Hierbei ist die Ruhespannung 43 eineindeutig durch den Ladezustand und umgekehrt bestimmt. Mit anderen Worten ist die Ruhespannungskennlinie 43 injektiv und surjektiv, sodass aus einer Messung der Ruhespannung 43 der Ladezustand der Batteriezelle eindeutig ermittelt werden kann.

Das rechte Diagramm zeigt die zeitliche Abhängigkeit der Ruhespannung 44 der Batteriezelle bei einer lastfreien Lagerung. Hierbei sinkt die Ruhespannung 44 mit der Zeit von einem maximalen Wert $V_{Start}$ zum Beginn beziehungsweise zum Start der Lagerung auf einen minimalen Wert $V_{Ende}$ zum Ende der Lagerung. Die Ruhespannung 44 der Batteriezelle zum Beginn und zum Ende ihrer Lagerung sind somit verschieden, sodass ebenfalls die zugehörigen ersten und zweiten Ladezustände verschieden sind. Die Diagramme verdeutlichen zudem in Kombination, dass der zweite Ladezustand am Ende der Lagerung geringer als der erste Ladezustand zu Beginn der Lagerung ist.

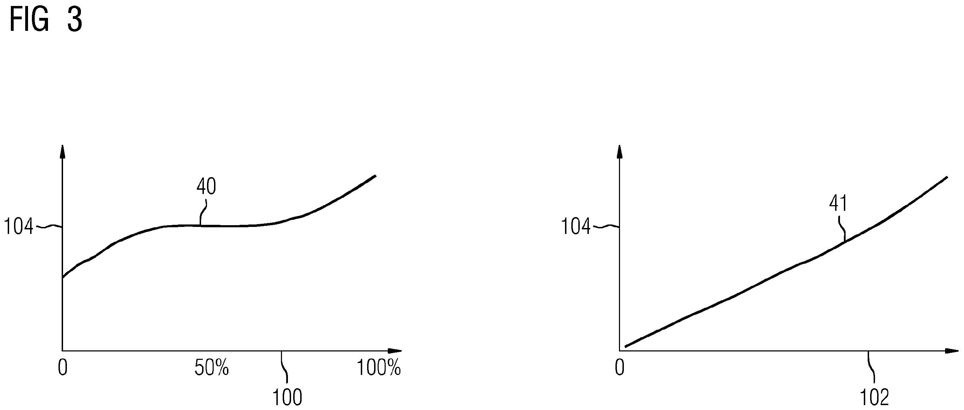

Die Figur 3 zeigt ein linkes und rechtes Diagramm, welche jeweils eine typische Ausdehnungskennlinie 40, 41 darstellen.

An der Abszisse 100 des linken Diagramms ist der Ladezustand (SOC) der Batteriezelle in Prozent aufgetragen.

An der Abszisse 102 des rechten Diagramms ist der Kapazitätsverlust $\Delta Q$, insbesondere in Einheiten einer Ladungsmenge, aufgetragen.

An den Ordinaten 104 der Diagramme ist die jeweilige Ausdehnung der Batteriezelle in beliebigen Einheiten aufgetragen. Hierbei zeigt das linke Diagramm eine (Gesamt-)Ausdehnung der Batteriezelle und das rechte Diagramm eine relative Ausdehnung, das heißt eine Ausdehnungsänderung (vergleiche Werte bei SOC = 0 %).

Das linke Diagramm zeigt die ladezustandsabhängige Ausdehnungskennlinie $D_{SOC}(SOC)$ 40, die bei einer initialen Ausdehnung $D_0$ der Batteriezelle beginnt. Hierbei ist die Ausdehnung der Batteriezelle abhängig von ihrem Ladezustand. Die Batteriezelle weist typischerweise, wenn sie entladen ist, die minimale Ausdehnung $D_0$ auf. Ist die Batteriezelle vollständig geladen, das heißt es gilt SOC = 100 %, dann weist diese typischerweise eine maximale Ausdehnung auf. Hierbei ist der genaue Verlauf der Kennlinie vom Batterietyp abhängig.

Das rechte Diagramm zeigt die vom Kapazitätsverlust $\Delta Q$ abhängige Ausdehnungskennlinie $D_{loss}(\Delta Q)$ 41. Diese steigt mit dem Kapazitätsverlust $\Delta Q$ an. Dies ist insbesondere für die Alterung von Lithium-Ionen-Batterien beziehungsweise Lithium-Ionen-Batteriezellen der Fall. Die Abhängigkeit der Ausdehnung 41 vom Kapazitätsverlust, welche durch die dargestellte Ausdehnungskennlinie quantifiziert ist, kann vorab durch Testmessung batteriezellenspezifisch ermittelt werden. Hierbei ändert sich $D_{loss}(\Delta Q)$ der Batteriezelle durch den Kapazitätsverlust $\Delta Q$ in Folge der Alterung.

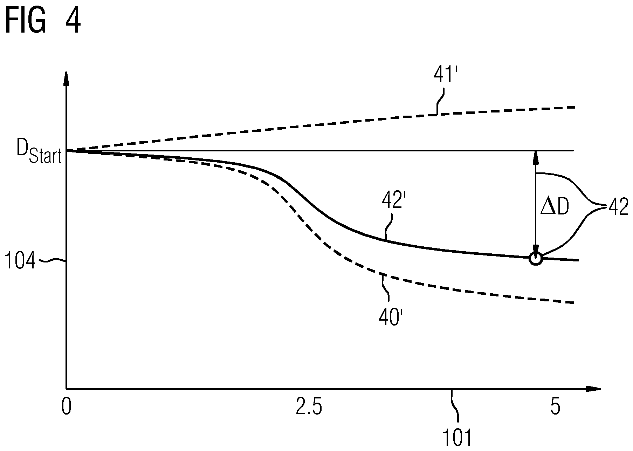

Die Figur 4 zeigt ein Diagramm bezüglich einer zeitlichen Ausdehnungsänderung der Batteriezelle.

An der Abszisse 101 des Diagramms ist die Zeit, insbesondere die Lagerdauer, in Tagen aufgetragen.

An der Ordinate 104 des Diagramms ist die (Gesamt-)Ausdehnung der Batteriezelle in beliebige Einheiten aufgetragen.

Zum Beginn der Lagerung weist die Batteriezelle eine initiale Ausdehnung $D_{Start}$ auf. Die Ausdehnung ist hierbei beispielsweise die absolute, relative oder normierte Größe der Batteriezelle in eine räumliche Richtung, beispielsweise ihrer Höhe, Breite und/oder Tiefe, oder ihr Volumen.

Das Diagramm zeigt drei verschiedene zeitabhängige Ausdehnungskurven 40', 41', 42'.

Die Ausdehnungskurve 40' zeigt die Zeitabhängigkeit der vom Ladezustand SOC abhängigen (Gesamt-)Ausdehnung, das heißt $D_{SOC}(SOC)$. Diese korrespondiert zur Selbstentladung der Batteriezelle.

Die Ausdehnungskurve 41' zeigt die Zeitabhängigkeit der vom Kapazitätsverlust $\Delta Q$ abhängigen Ausdehnung $D_{Start} + D_{loss}(\Delta Q)$, wobei diese vorliegend auf $D_{Start}$ bezogen wurde.

Die Ausdehnungskurve 42' zeigt die Zeitabhängigkeit der messbaren (Gesamt-)Ausdehnung $D_{measure}$ der Batteriezelle. Diese korrespondiert, wenn nur Änderungen zur initialen Ausdehnung betrachtet werden, zur Zeitabhängigkeit der messbaren Ausdehnungsänderung $\Delta D$. Mit anderen Worten ist $D_{measure} = D_{SOC}(SOC) + D_{loss}(\Delta Q)$ und somit $\Delta D = D_{SOC}(SOC_2) - D_{SOC}(SOC_1) + D_{loss}(\Delta Q) = D_{SOC}(SOC_2) - D_{Start} + D_{loss}(\Delta Q)$. Hierbei entspricht die Differenz $\Delta D$ der messbaren Ausdehnungen am Anfang und Ende des Alterungsprozesses, insbesondere während der Lagerung. Ein möglicher Messwert beziehungsweise Messzeitpunkt von $\Delta D$ ist im Diagramm symbolisch mit dem Bezugszeichen 42 gekennzeichnet.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

Bezugszeichenliste

S1    erster Schritt
S2    zweiter Schritt
S3    dritter Schritt
S4    vierter Schritt
S5    fünfter Schritt

S6       sechster Schritt

40       Ausdehnungskennlinie $D_{\text{SOC}}$(SOC)
40'      Zeitabhängigkeit Ausdehnungskennlinie $D_{\text{SOC}}$ (SOC)
41       Ausdehnungskennlinie $D_{\text{loss}}(\Delta Q)$
41'      Zeitabhängigkeit Ausdehnungskennlinie $D_{\text{loss}}$ ($\Delta Q$)
42       Messwert Ausdehnungsänderung $\Delta D$
42'      Zeitabhängigkeit Ausdehnungsänderung $\Delta D$
43       Ruhespannung $V_{\text{OC}}$(SOC)
44       Zeitabhängigkeit $V_{\text{OC}}$(SOC)

100, 101, 102      Abszisse
103, 104      Ordinate

**Patentansprüche**

1. Verfahren zur Ermittlung eines kalendarischen Kapazitätsverlusts $\Delta Q$ einer Batteriezelle über einen festgelegten Zeitbereich, **gekennzeichnet durch** folgende Schritte:

   - (S1) Bereitstellen eines ersten Ladezustands $SOC_1$ zu einem Anfang des Zeitbereichs;
   - (S2) Ermitteln eines zweiten Ladezustands $SOC_2$ zu einem Ende des Zeitbereichs;
   - (S3) Bereitstellen einer ladezustandsabhängigen Ausdehnungskennlinie $D_{\text{SOC}}$(SOC) (40);
   - (S4) Bereitstellen einer vom Kapazitätsverlust $\Delta Q$ abhängigen Ausdehnungskennlinie $D_{\text{loss}}$ ($\Delta Q$) (41);
   - (S5) Erfassen einer Ausdehnungsänderung $\Delta D$ (42) der Batteriezelle zwischen Anfang und Ende des Zeitbereichs; und
   - (S6) Ermitteln des Kapazitätsverlusts $\Delta Q$ mittels des Zusammenhangs $\Delta D = D_{\text{SOC}}(SOC_2) - D_{\text{SOC}}(SOC_1) + D_{\text{loss}}(\Delta Q)$.

2. Verfahren gemäß Anspruch 1, **gekennzeichnet dadurch, dass** eine kalendarische Alterung mittels $\Delta Q/Q_0$ ermittelt wird, wobei $Q_0$ die Nennkapazität der Batteriezelle bezeichnet.

3. Verfahren gemäß Anspruch 1 oder 2, **gekennzeichnet dadurch, dass** eine kalendarische Alterungsrate mittels $\Delta Q/T_0$ ermittelt wird, wobei $T_0$ die Zeitdauer des Zeitbereichs bezeichnet.

4. Verfahren gemäß einem der vorhergehenden Ansprüche, **gekennzeichnet dadurch, dass** die Batteriezelle innerhalb des Zeitbereichs lastfrei gelagert wird.

5. Verfahren gemäß einem der vorhergehenden Ansprüche, **gekennzeichnet dadurch, dass** die Ausdehnungskennlinien (40, 41) in Abhängigkeit des Zelltyps der Batteriezelle bereitgestellt werden.

6. Verfahren gemäß einem der vorhergehenden Ansprüche, **gekennzeichnet dadurch, dass** eine maximale Kapazität der Batteriezelle ermittelt wird, und der ermittelte Kapazitätsverlust $\Delta Q$ mittels eines von der ermittelten maximalen Kapazität abhängigen Korrekturfaktors korrigiert wird.

7. Verfahren gemäß einem der vorhergehenden Ansprüche, **gekennzeichnet dadurch, dass** der erste und/oder zweite Ladezustand $SOC_1$, $SOC_2$ mittels einer Ruhespannungskennlinie $V_{\text{OC}}$(SOC) (43) der Batteriezelle ermittelt werden.

8. Verfahren gemäß einem der vorhergehenden Ansprüche, **gekennzeichnet dadurch, dass** die Ausdehnungsänderung $\Delta D$ (42) mittels eines Dilatometers, einer Kraftmessung, einer Druckmessung, ultraschallbasierten Verfahren, optischen Verfahren und/oder mittels Dehnungsmessstreifen erfasst wird.

9. Verfahren gemäß einem der vorhergehenden Ansprüche, **gekennzeichnet dadurch, dass** die Batteriezelle als Lithium-Ionen-Batteriezelle ausgebildet ist.

10. Herstellungsverfahren für eine Batteriezelle, bei welchem die Batteriezelle für wenigstens einen Zeitbereich lastfrei gelagert wird, **gekennzeichnet dadurch, dass** ein kalendarischer Kapazitätsverlust der Batteriezelle über die Lagerung mittels einem Verfahren gemäß einem der vorhergehenden Ansprüche ermittelt wird.

11. Herstellungsverfahren gemäß Anspruch 10, **gekennzeichnet dadurch, dass** die kalendarische Alterung der Batteriezelle über die Lagerung gemäß Anspruch 2 ermittelt wird.

12. Herstellungsverfahren gemäß Anspruch 10 oder 11, **gekennzeichnet dadurch, dass** die kalendarische Alterungsrate der Batteriezelle über die Lagerung gemäß Anspruch 3 ermittelt wird.

13. Herstellungsverfahren gemäß einem der Ansprüche 10 bis 12, **gekennzeichnet dadurch, dass** der kalendarische Kapazitätsverlust gemäß Anspruch 6 korrigiert wird.

14. Herstellungsverfahren gemäß einem der Ansprüche 10 bis 13, **gekennzeichnet dadurch, dass** als Batteriezelle eine als Lithium-Ionen-Batteriezelle hergestellt wird.

FIG 1

FIG 2

# FIG 3

FIG 4

**Europäisches Patentamt**
**European Patent Office**
**Office européen des brevets**

## EUROPÄISCHER RECHERCHENBERICHT

Nummer der Anmeldung

EP 24 18 2138

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | DE 10 2021 005418 A1 (DAIMLER AG [DE]) 16. Dezember 2021 (2021-12-16) * Absätze [0002], [0006], [0008], [0009] * | 1-14 | INV. G01R31/392 H01M10/48 |
| A | CANNARELLA JOHN ET AL: "State of health and charge measurements in lithium-ion batteries using mechanical stress", JOURNAL OF POWER SOURCES, ELSEVIER, AMSTERDAM, NL, Bd. 269, 9. Juli 2014 (2014-07-09), Seiten 7-14, XP029043904, ISSN: 0378-7753, DOI: 10.1016/J.JPOWSOUR.2014.07.003 * 3.3 Stress-SOH/SOC relationships for battery monitoring * | 1-14 | |
| A | US 2018/149462 A1 (GHANTOUS DANIA [US] ET AL) 31. Mai 2018 (2018-05-31) * Absatz [0068] * | 1-14 | |

RECHERCHIERTE SACHGEBIETE (IPC)

G01R
H01M

Der vorliegende Recherchenbericht wurde für alle Patentansprüche erstellt

| Recherchenort | Abschlußdatum der Recherche | Prüfer |
|---|---|---|
| München | 25. November 2024 | Bossen, Michael |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

EP 4 664 132 A1

## ANHANG ZUM EUROPÄISCHEN RECHERCHENBERICHT
## ÜBER DIE EUROPÄISCHE PATENTANMELDUNG NR.

EP 24 18 2138

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-11-2024

| Im Recherchenbericht angeführtes Patentdokument | Datum der Veröffentlichung | Mitglied(er) der Patentfamilie | Datum der Veröffentlichung |
|---|---|---|---|
| DE 102021005418 A1 | 16-12-2021 | KEINE | |
| US 2018149462 A1 | 31-05-2018 | CN 105548889 A | 04-05-2016 |
| | | US 2016116548 A1 | 28-04-2016 |
| | | US 2018149462 A1 | 31-05-2018 |

EPO FORM P0461

Für nähere Einzelheiten zu diesem Anhang : siehe Amtsblatt des Europäischen Patentamts, Nr.12/82